# EUROPEAN PATENT APPLICATION

(11) **EP 1 615 039 A1**
(43) Date of publication of application: **11.01.2006**
(21) Application number: 05076478.6
(22) Date of filing: 27.06.2005
(51) Int. Cl.: G01R 15/06, H01B 17/00

(54) **Voltage-measuring device for a high-voltage installation**

(30) Priority: 06.07.2004 IT PD20040180
(71) Applicant: S.G.E. Società Generale di Elettronica S.r.l., 35127 Padova (IT)
(72) Inventor: Berton, Mario, 35010 Vigonza (PD) (IT); Michielutti, Loris, 30030 S. Bruson di Dolo (VE) (IT)
(74) Representative: Gerbino, Angelo

(57) **Abstract**

Voltage measuring device for electrical applications, which can be operationally associated with the cable of a line in order to detect a voltage signal on an insulator, in particular of a network apparatus, formed by a feed-through capacitor arranged coaxially with the cable and able to be connected to a capacitive divider for detecting the voltage signal. The feed-through capacitor is in the form of a metal strap embedded in a layer of insulating material and able to be closed in the manner of a ring around the insulator by closing means in particular consisting of strips of Velcro. The abovementioned device may be advantageously associated with a measuring device for detecting a current signal, comprising substantially in turn a Rogowsky coil formed in at least one printed circuit.

## Description

The present invention concerns a voltage measuring device for electrical applications.

The measuring device in question may be advantageously used to provide voltage values of electric cables in particular in the vicinity of insulators for isolating switches, for transformers or for other network apparatus or solely for the cable support on the pylons.

More particularly, the device according to the present invention is able to transmit to fault signalling devices the voltage signals which are necessary for operation thereof and for setting the systems for remote control of the electric lines.

As is known, in the sector relating to electric power distribution by means of high-voltage and low-voltage lines there is an increasingly widespread need to acquire specific voltage data in order to ensure optimum management of the line and in particular allow increasingly more reliable detection of the faulty sections by means of remote-controlled systems.

In more detail, nowadays there is an increasingly greater use of fault detectors able to communicate with a central operating station in order to signal the presence of faults of various types (earth discharges, short-circuits between phases, etc.). These detectors may be provided in the vicinity of both isolating switches arranged along the main sections of the lines and isolating switches arranged along secondary transverse lines or in the area where the so-called "pole isolating switches" are situated.

As is known, at present the voltage signals may already be supplied by the said isolating switches via special capacitive dividers.

In pole isolating switches where the latter are not envisaged, these signals must be taken from the line by means of the installation of voltage transformers VT, with high costs and considerable maintenance expenses.

In order to ensure detection of the voltage of the lines in a simpler and more economical manner, numerous designs of isolating switches for isolating transformers or the like have been introduced lately onto the market, said designs being provided internally with at least one capacitance from which it is possible to extract a voltage signal with respect to the earth potential by means of an electrical connection connected to the base of the insulator and arranged so as to pass inside the metal cabinet containing the network apparatus. Some of these designs are for example described in the patents DE 196 44 482, DE 100 00 243 and EP 134 541.

The patent EP 688 075 describes a modular insulator provided with several rings able to be arranged axially on top of each other so as to provide the desired insulation and provided internally with capacitances which are arranged in series once the rings have been stacked on top of each other.

The voltage signal which is detected is proportional to that to be measured and is obtained by means of a capacitive divider in accordance with the known relation V=VₒC₁/(C₁+C₂) where C₁ is the capacitance inside the insulator, C₂ is the capacitance of the measuring device, and Vₒ is the phase voltage to be measured.

This latter solution does not take into account that in most cases the network apparatus are already installed and it may therefore be very difficult to replace them with other new ones having insulators with a capacitance incorporated inside.

Moreover, it must be taken into account that the sulphur hexafluoride (SF₆) separators, which at present are preferred since they allow a more compact assembly and considerable ease as regards remote control, are contained in a sealed metallic box-like body from which it is difficult and awkward to extract wires for measuring the voltage.

The main object of the present invention is therefore to overcome the drawbacks arising from the solutions of the known type mentioned above, by providing a voltage measuring device for electrical applications, which may be easily installed along lines, in particular on insulators of electrical apparatus in a simple and low-cost manner.

A further object of the present invention is to provide a measuring device which does not require separation of the cable from the line or from the electrical apparatus in order to be installed.

A further object of the present invention is to provide a measuring device for detecting the voltage of line cables which is constructionally simple and inexpensive to produce and operationally entirely reliable.

A further object of the present invention is to provide a measuring device for detecting both the voltage and the current of line cables, which is simple and inexpensive to produce and operationally entirely reliable.

The technical features of the invention, in accordance with the abovementioned objects, may be determined from the contents of the claims below and the advantages thereof will emerge more clearly from the detailed description which follows, provided with reference to the accompanying drawings which show some purely exemplary and non-limiting embodiments and where:
- Figure 1 shows schematically an overall view of a strap forming part of a first example of a measuring device according to the present invention;
- Figure 2A shows the strap according to Figure 1 installed on an insulator with the function of a feed-through capacitor;
- Figure 2B shows the strap according to Figure 1 installed on a cable;
- Figure 3 shows in simplified form the circuit diagram of the voltage measuring device;
- Figure 4 shows a variation of embodiment of the present invention illustrating an assembly consisting of the voltage measuring device and a current measuring device;
- Figure 5 shows in a simplified manner the circuit diagram of the current measuring device shown in Figure 4.

In accordance with the figures of the accompanying drawings, 1 denotes respectively in its entirety a first example of a measuring device for electrical applications according to the present invention.

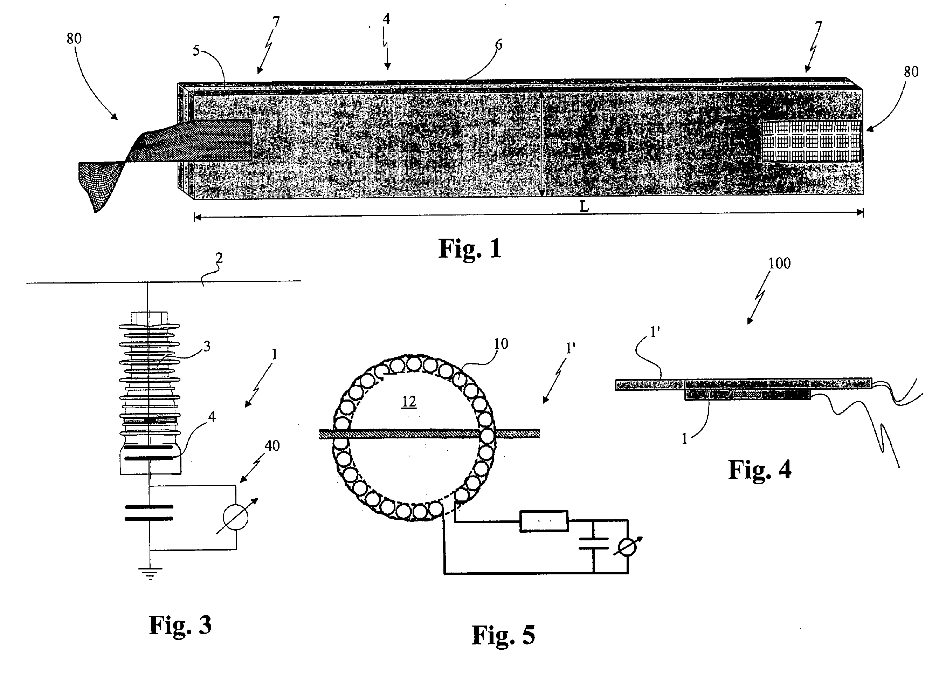

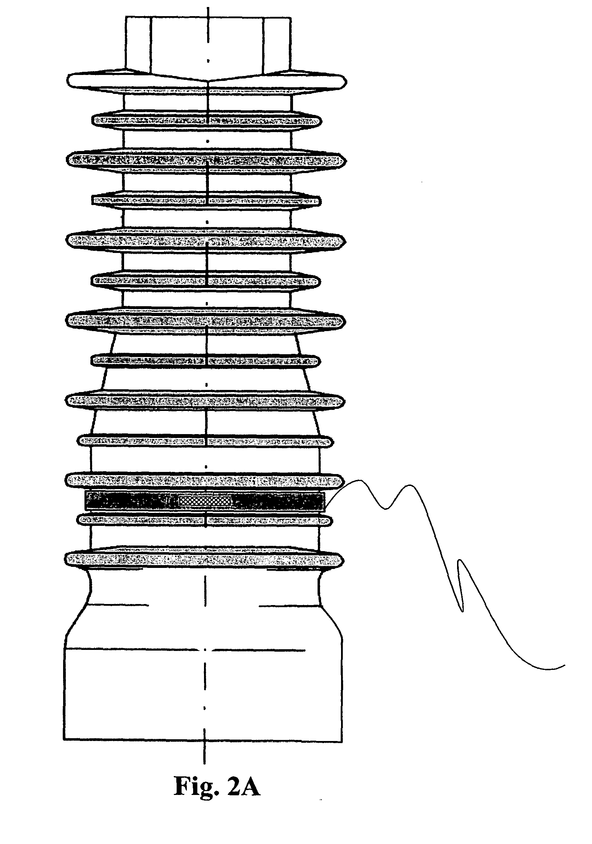

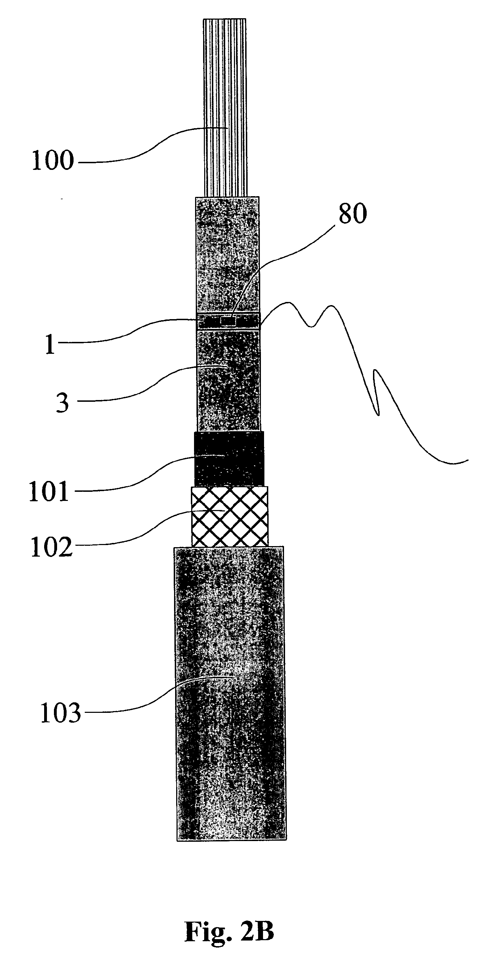

In accordance with the example of embodiment shown in Figures 1, 2 and 3, the device 1 may be operationally associated with a cable 2 of an electric line, for example a three-phase medium-voltage line, for measuring a signal indicating the phase voltage of the line.

Advantageously, the device is intended to be installed on an insulator 3 in particular of a network apparatus such as an isolating switch or a transformer, per se of any type available on the market.

The abovementioned device 1 comprises a feed-through capacitor 4 able to be arranged coaxially with the line cable, the voltage of which is to be measured.

From an operational point of view, it may for example be connected for detection of the voltage signal to a capacitive divider, which is per se of the known type and therefore not described in detail here, but only indicated schematically by 40 in the accompanying Figure 4.

According to the idea forming the basis of the present invention, the feed-through capacitor 4 is in the form of a metal strap 5 able to be closed and fastened in the manner of a collar around the insulator 3, via its ends 7, 7' arranged together by means of closing means 80.

As will be clarified below, the insulator may consist of an insulator for overhead lines (see example of Figure 2A) or an insulator for cables of the type intended to be used for conveying power along underground line sections (see example of Figure 2B).

The abovementioned metal strap 5 may be bare, i.e. without a covering lining or may alternatively be embedded in a layer of insulating material 6 (below the strap will be referred to in both cases overall as "strap 4").

The abovementioned closing means 80 may be formed in various ways, i.e. may be both fixed and removable, without thereby departing from the scope of protection of the present invention, and preferably will consist of removable tear-type means in particular of the Velcro type (registered trademark) where two surfaces, one covered with hooks and the other with loops or eyelets, are joined together. The characteristics of Velcro are such that the strap 4 may be opened easily, but may otherwise remain firmly fastened when necessary. Obviously, additional or alternative systems may also be envisaged for fastening the strap 4 in the appropriate seat of the insulator 3, said systems consisting purely by way of example of insulating tape wound around the strap 4.

The height H and the length L of the strap 4, and therefore the radius of the collar of the metal part 5, as well as the type of metal may be chosen depending on the requirements in order to obtain a capacitance C of the desired value and at the same time also obtain optimum adhesion of the strap 4 to the seat of the insulator 3.

In more detail, the seat of the insulator consists of an annular seat 8 which is defined between two adjacent projecting rings 9 of the insulator 3 and is preferably chosen from one of the last three annular seats viewed as from the tapered end 50 of the insulator 3 inside which the cable 2 enters, it being necessary to ensure insulation between cable and strap.

This same measuring device, moreover, may also be installed around a cable - for example a medium-voltage cable - intended in particular for conveying power along underground line sections.

In the example shown in Figure 2B, the cable is of the type composed of a core 100 consisting of a metal conductor which forms the bare cable and lined with an internal insulator 3 in turn externally covered by a semi-conductive layer 101 able to favour, in the case of leakages, the superficial flowing of the current without damaging the insulator and by a metal mesh 102 for connection to earth. Finally, a second insulator 103 is provided externally.

The strap 4 must be conveniently arranged at an insulating distance S from the bare cable, which will be greater in the case where the cable does not have its own insulating lining.

In accordance with a constructional variation of the present invention, the strap may be arranged directly on the bare cable and in this case an insulator layer will be arranged in between.

As is known, in some electrical applications, the line cable 2 is fixed to the front end 50 of each insulator 3 of the network apparatus by means of a nut which thus allows rapid connection and disconnection thereof from the said network apparatus.

Alternatively, in other applications, the operation of separating the line cable 2 from the network apparatus may be very problematic and uneconomic both in terms of time and in the terms of installation costs.

In particular in the case of these latter applications, the solution according to the present invention, which allows the use of voltage measuring devices 1 able to be installed without disconnecting the line cables 2, is extremely advantageous and allows significant savings in time and installation costs compared to voltage transformers VT of the known and conventional type.

A device for measuring the current 1' of an electric line may also be operationally associated with this measuring device 1. This device comprises essentially, in accordance with the diagram of Figure 5, a Rogowsky coil 10 formed on a printed circuit provided with a central opening 12 and consisting of radial depositions provided on both sides of the printed circuit 11 and electrical connections between the radial depositions of the two sides.

If it should be possible as explained above to perform easily separation of the line cable 2 from the network apparatus, for example by simply loosening a bolt, the Rogowsky coil 10 may be simple inserted once the cable 2 has been detached.

In this case, in accordance with the embodiment shown in Figure 4, the two measuring devices 1 and 1' may be associated with each other not only operationally, but also mechanically.

In more detail, Figure 4 shows a measuring assembly 100 which may be operationally associated with a cable 2 of an electric line, comprising the device 1 for detecting a voltage signal described above, where the strap 4 is rigidly fastened so as to form a closed collar which is embedded in a layer of insulating material, and the device 1' for detecting a current signal described above, where the Rogowsky coil 10 is embedded in a layer of insulating material, which forms a single body with the insulating layer of the strap 4 so as to bond the two devices 1 and 1' rigidly together.

The two devices 1, 1' are fixed coaxially on top of each other so that the collar is concentric with the opening 12 of the Rogowsky coil 10.

The constructional simplicity of this assembly 100 has a favourable impact on the installation costs.

The invention thus conceived therefore achieves the predefined objects.

Obviously it may also assume, in its practical embodiment, forms and configurations different from that illustrated above without thereby departing from the present scope of protection. Moreover, all the details may be replaced by technically equivalent elements, and the forms, dimensions and materials used may be of any nature depending on the requirements.

## Claims

1. Voltage measuring device for electrical applications, which may be operationally associated with the cable of a line in order to detect a voltage signal on an insulator with a series of projecting adjacent rings in particular of a network apparatus, comprising at least one feed-through capacitor arranged coaxially with said cable and able to be connected to a capacitive divider in order to detect said voltage signal, **characterized in that** said feed-through capacitor is in the form of a metal strap with two ends shaped so that it can be inserted into an annular seat defined between two projecting adjacent rings of said insulator, and **in that** said device comprises closing means mechanically able to fasten said strap with its two ends arranged together around the outer surface of said insulator, inside said seat.

2. Voltage measuring device for electrical applications, according to Claim 1, **characterized in that** said metal strap is fastened around one of the last three annular seats defined by the series of projecting rings of the insulator, as considered from the tapered end of the insulator inside which the cable enters.

3. Voltage measuring device for electrical applications, which may be operationally associated with the cable of a line in order to detect a voltage signal, comprising at least one feed-through capacitor arranged coaxially with said cable and able to be connected to a capacitive divider in order to detect said voltage signal, **characterized in that** said feed-through capacitor is in the form of a metal strap which can be fastened by closing means with two ends arranged together, in a coaxial position, outside and around said cable with an insulator arranged between.

4. Voltage measuring device for electrical applications, according to Claim 1, **characterized in that** said metal strap is at least partially embedded in a layer of insulating material.

5. Voltage measuring device for electrical applications, according to Claim 1, **characterized in that** said closing means consist of tear-type means, in particular of Velcro.

6. Measuring assembly for electrical applications, which may be operationally associated with the cable of an electric line, comprising: at least one device for detecting a voltage signal provided with a feed-through capacitor arranged coaxially with said cable and able to be connected to a capacitive divider in order to detect said voltage signal, and in the form of a metal collar at least partially embedded in a layer of insulating material; at least one device for detecting a current signal, provided with at least one Rogowsky coil formed in at least one printed circuit embedded at least partially in a layer of insulating material and provided with a central opening, said coil being formed by radial depositions provided on both sides of the printed circuit and electrical connections arranged between the depositions of the two sides, said printed circuit being assembled axially with said capacitive divider so as to form a single body with the associated insulating layers rigidly connected to each other.
